# EUROPÄISCHE PATENTSCHRIFT

(11) **EP 3 121 965 B1**
(45) Veröffentlichungstag und Bekanntmachung des Hinweises auf die Patenterteilung: **08.07.2020**
(21) Anmeldenummer: 15177670.5
(22) Anmeldetag: 21.07.2015
(51) Int. Cl.: H03K 17/96

(54) **BEDIENEINRICHTUNG FÜR EIN ELEKTROGERÄT SOWIE ELEKTROGERÄT UND VERFAHREN ZUR HERSTELLUNG EINES FOLIENTRÄGERS**
OPERATING DEVICE FOR AN ELECTRICAL DEVICE AND ELECTRICAL DEVICE AND METHOD FOR PRODUCING A FILM CARRIER
DISPOSITIF DE COMMANDE D'APPAREIL ELECTRIQUE ET APPAREIL ELECTRIQUE ET PROCEDE DE FABRICATION D'UN FILM SUPPORT

(43) Veröffentlichungstag der Anmeldung: 25.01.2017
(73) Patentinhaber: E.G.O. Elektro-Gerätebau GmbH, 75038 Oberderdingen (DE)
(72) Erfinder: Rominger, Michael, 78078 Niedereschach (DE); Fiedler, Dr. Mathias, 71263 Merklingen (DE); Seyfang, Jürgen, 74343 Sachsenheim (DE)
(74) Vertreter: Patentanwälte Ruff, Wilhelm, Beier, Dauster & Partner mbB

(56) Entgegenhaltungen:
- EP-A2- 1 924 000
- US-A1- 2008 202 912
- US-A1- 2011 041 409
- US-A1- 2011 247 884
- US-B1- 6 403 904

## Beschreibung

Die Erfindung betrifft eine Bedieneinrichtung für ein Elektrogerät sowie ein solches Elektrogerät, insbesondere ein Kochfeld. Des Weiteren betrifft die Erfindung ein Verfahren zur Herstellung eines flexiblen Trägers bzw. Folienträgers für eine solche Bedieneinrichtung.

Es ist aus der EP 2809006 A1 bekannt, eine Bedieneinrichtung für ein Elektrogerät bzw. für ein Kochfeld mit kapazitiven Berührungsschaltern zu versehen. Um diese kapazitiven Berührungsschalter zu bilden, sind auf einem Bauteilträger unter einer Bedienblende der Bedieneinrichtung kapazitive Sensorelemente in Form von elektrisch leitfähigem Sensormaterial auf der Oberseite von Kunststoffgehäusen vorgesehen.

Grundsätzlich ähnliche kapazitive Berührungsschalter sind bereits aus der EP 859467 A2 bekannt.

Aus der EP 1924000 A2 ist eine Bedieneinrichtung für ein Elektrohaushaltsgerät bekannt, die kapazitive Berührungsschalter aufweist. Unter einer Blende, die mit Symbolen bedruckt ist, ist ein Flexträger angebracht bzw. an die Unterseite angelegt, der elektrisch leitfähiges Sensormaterial aufweist für die kapazitiven Berührungsschalter. Dieses Sensormaterial kann beispielsweise Silber, Kupfer oder Zinn sein.

Aus der US 2011/0041409 A1 ist es bekannt, für eine Bedieneinrichtung eine flexible Leiterplatte zu verwenden, auf der kapazitive Berührungsschalter durch Sensorelemente, bestehend aus Sensormaterial wie beispielsweise Kupfer, gebildet werden.

### Aufgabe und Lösung

Der Erfindung liegt die Aufgabe zugrunde, eine eingangs genannte Bedieneinrichtung, ein damit versehenes Elektrogerät sowie ein Verfahren zur Herstellung eines Folienträgers bzw. Flexträgers für eine solche Bedieneinrichtung zu schaffen, mit denen Probleme des Standes der Technik gelöst werden können und es insbesondere möglich ist, eine solche Bedieneinrichtung gut und günstig herzustellen sowie einfach zu montieren, wobei die Bedieneinrichtung zuverlässig und dauerhaft arbeitet.

Gelöst wird diese Aufgabe durch eine Bedieneinrichtung mit den Merkmalen des Anspruchs 1, ein Elektrogerät mit den Merkmalen des Anspruchs 13 sowie ein Verfahren mit den Merkmalen des Anspruchs 14. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung, nur für das Elektrogerät oder nur für das Verfahren beschrieben. Sie sollen jedoch unabhängig davon sowohl für die Bedieneinrichtung als auch für das Elektrogerät sowie das Verfahren selbständig gelten können. Der Wortlaut der Ansprüche wird durch ausdrückliche Bezugnahme zum Inhalt der Beschreibung gemacht.

Es ist vorgesehen, dass die Bedieneinrichtung für ein Elektrogerät mindestens einen kapazitiven Berührungsschalter aufweist, vorteilhaft mehrere. Die Bedieneinrichtung weist eine Bedienblende auf sowie einen Bauteilträger, der unter der Bedienblende angeordnet ist und der vorzugsweise eine Leiterplatte ist. Auf dem Bauteilträger sind verschiedene Bauteile angeordnet, wobei dies mindestens Schaltungsbauteile bzw. aktive und/oder passive Bauteile sowie ggf. Steuerungen bzw. Mikrocontroller umfasst. Ebenso sind Leuchtanzeigen bzw. Leuchtmittel vorgesehen, beispielsweise in Form von SMD-LED, welche über sich ein Gehäuse zur definierten Lichtführung aufweisen können.

Ein flexibler Träger bzw. Folienträger, der einen Flexträger bildet und im Folgenden als Flexträger bezeichnet wird, verläuft oberhalb der Bauteile über dem Bauteilträger und unterhalb der Bedienblende. Der Flexträger kann an die Unterseite der Bedienblende angelegt sein und beispielsweise von den Bauteilen angedrückt werden. Der Flexträger ist zumindest bereichsweise lichtdurchlässig, wobei er vorteilhaft Maskierungen bzw. Ausschnitte in Form von Symbolen, Zahlen und/oder Buchstaben aufweisen kann. Er kann auch eingefärbt sein in den lichtdurchlässigen Bereichen, so dass verschiedenartige Leuchtanzeigen darstellbar sind.

Auf mindestens einer der Seiten des Flexträgers ist elektrisch leitfähiges elastisches Sensormaterial angeordnet, das den kapazitiven Berührungsschalter bildet bzw. ein entsprechendes kapazitives Sensorelement dafür bildet. Das Sensormaterial weist vorteilhaft die Form von länglichen Abschnitten und/oder Winkeln und/oder Umrahmungen auf. Besonders vorteilhaft können solche Winkel oder Umrahmungen an einem vorgenannten lichtdurchlässigen Bereich vorgesehen sein, also benachbart zu diesem sein bzw. ihn einschließen oder umschließen. Dieses Sensormaterial weist eine Dicke bzw. Höhe auf, die über diejenige einer reinen Beschichtung hinausgeht und 0,1 mm bis 2 mm über der Oberfläche des Flexträgers betragen kann. Dadurch ist es insbesondere möglich, dass das auf der Oberseite des Flexträgers angeordnete Sensormaterial an die Unterseite der Bedienblende angedrückt ist, insbesondere elastisch bzw. federnd, der Flexträger selbst aber noch einen geringen Abstand aufweist.

Auf dem Flexträger sind Leiterbahnen vorgesehen, die einerseits mit dem Sensormaterial elektrisch verbunden sind, beispielsweise durch flächige Auflage, und andererseits an eine Kontaktierungseinrichtung des Flexträgers geführt sind, insbesondere zum elektrischen Anschluss an den Bauteilträger. Eine Ansteuerung und Auswertung der kapazitiven Sensorelemente des Flexträgers ist vorteilhaft über eine Steuerung auf dem Bauteilträger möglich.

Somit ist es mit der Erfindung möglich, dass für eine Bedieneinrichtung mit mindestens einem oder mehreren kapazitiven Berührungsschaltern nicht mehrere einzelne Teile vorgesehen werden müssen, die diese Berührungsschalter im Einzelnen bilden, sondern ein einziges Teil vorgesehen ist. Der Flexträger kann für diesen Zweck ausreichen. Die Sensorelemente bzw. das Sensormaterial können in einem einfachen großserientauglichen Verfahren aufgebracht werden, welches nachfolgend noch näher erläutert wird, beispielsweise einem Druckverfahren.

In vorteilhafter Ausgestaltung der Erfindung ist das Sensormaterial ausschließlich an der Oberseite des Flexträgers vorgesehen. So weisen sämtliche davon gebildeten kapazitiven Sensorelemente dieselbe Position zur Bedienblende auf, was für eine stabile und gut auswertbare Funktion der Bedieneinrichtung vorteilhaft ist.

Die vorgenannten Leiterbahnen sind vorteilhaft auf der Oberseite des Flexträgers angeordnet. Besonders vorteilhaft sind sie überwiegend oder sogar ausschließlich auf der Oberseite des Flexträgers angeordnet. So ist deren Herstellung leichter, da ein Aufbringungsverfahren nur auf einer Seite einmal angewendet werden muss. Sollte die Notwendigkeit für eine Vielzahl von Leiterbahnen bestehen, deren Dichte auf der Oberseite des Flexträgers nicht mehr untergebracht werden kann oder die Überkreuzungen notwendig macht, ist ein Verlegen von Leiterbahnen auf die Unterseite des Flexträgers möglich mit entsprechenden Techniken, die von dünnen Leiterplatten bzw. folienartigen Leiterplatten bekannt sind, insbesondere Durchkontaktierungen.

Der Flexträger besteht vorteilhaft aus Polycarbonat. Er kann grundsätzlich lichtdurchlässig sein, wobei nachfolgend noch beschrieben wird, wie eine weitgehende Abdeckung erfolgt mit Freilassen bestimmter Symbole, Zahlen und/oder Buchstaben. Die Dicke des Flexträgers kann zwischen 0,1mm bis 2mm betragen, vorteilhaft 0,3mm bis 0,6mm. Jedenfalls sollte er flexibel und reversibel biegbar sein sowie dünn wegen der Gesamthöhe der Bedieneinrichtung.

Das Sensormaterial weist erfindungsgemäß eine Co-Polymermatrix auf, die Acrylat-basiert ist. Diese ist expandiert bzw. aufgeschäumt worden, um die gewünschte Elastizität zu erreichen. Da dadurch eine Formelastizität gegeben ist, kann diese auf Dauer und auch bei wechselnden Temperaturverhältnissen beibehalten werden. Für dieses Expandieren bzw. Aufschäumen weist das Acrylat-basierte Co-Polymermaterial im Ausgangszustand Mikrokugeln auf, die mit Lösemittel gefüllt sind. Bei Temperaturbeaufschlagung nach dem Auftragen des Sensormaterials auf den Flexträger dehnt sich dieses Lösemittel aus, tritt aus den Mikrokugeln aus und vergrößert somit das Volumen des Sensormaterials, insbesondere um den Faktor 3 bis 8, vorzugweise um den Faktor 4 bis 6.

Bei der Erfindung sind dem Sensormaterial Leitadditive zugesetzt, die ein Leitnetzwerk im Sensormaterial bilden. Derartige Leitadditive können aus der folgenden Gruppe ausgewählt sein: Carbon-Nanofasern, Ag-beschichtete Glaspartikel bzw. Glas-Flakes, PEDOT:PSS, Graphit. Das PEDOT:PSS-Material ist Poly-3,4-ethylendioxythiophen-Polystyrolsulfonat, ein semi-lichtdurchlässiges elektrisch leitfähiges Polymer.

Der Abstand von lichtdurchlässigen Bereichen des Flexträgers zu dem Sensormaterial kann wenige Millimeter betragen, vorteilhaft 1mm bis 10mm oder sogar nur bis 5mm. So ist es wie allgemein bei kapazitiven Berührungsschaltern möglich, den Finger auf ein beleuchtetes Symbol, gebildet durch den hinterleuchteten lichtdurchlässigen Bereich, aufzulegen und damit den kapazitiven Berührungsschalter durch Beeinflussung des Sensorelements zu schalten.

In vorteilhafter Ausgestaltung der Erfindung wird das Sensormaterial in einem Druckverfahren auf den Flexträger bzw. bevorzugt auf ein Feld, gebildet aus Leitmaterial, aufgebracht. Dabei können Leitmaterial und Sensormaterial in weitgehend übereinstimmender Form aufgebracht sein. Für das Sensormaterial eignen sich Siebdruckverfahren oder Schablonendruckverfahren, unter Umständen auch ein 3D-Druckverfahren. Das vorbeschriebene Expandieren des Sensormaterials kann dann danach stattfinden.

In weiterer Ausgestaltung der Erfindung ist direkt auf den Flexträger, insbesondere auf seine Oberseite, sehr gut elektrisch leitfähiges Leitmaterial aufgedruckt. Dieses kann einerseits in etwa die Form des Sensormaterials bzw. des davon gebildeten kapazitiven Sensorelements aufweisen, so dass das Sensormaterial wie vorgenannt zur elektrischen Kontaktierung auf dieses Leitmaterial aufgebracht wird. Von diesem Leitmaterial gehen dann die Leiterbahnen ab als elektrischer Anschluss an das Sensormaterial. Die Leiterbahnen bestehen vorteilhaft aus demselben Leitmaterial und sind im selben Schritt aufgebracht. In einem nachfolgenden Schritt wird dann eben auf das Leitermaterial das Sensormaterial in der gewünschten Form aufgebracht.

Das Leitmaterial kann beispielsweise Carbonleitpaste, Silberleitpaste oder ein Leitlack sein. Es kann durch ein übliches Druckverfahren aufgebracht werden, insbesondere durch ein Inkjet-Verfahren oder Siebdruckverfahren, ebenso eignet sich ein Schablonendruckverfahren.

Um bei einem an sich lichtdurchlässigen Grundmaterial des Flexträgers zu erreichen, dass dieser nur bereichsweise lichtdurchlässig ist, kann eine lichtundurchlässige Abdeckschicht aufgebracht sein. Vorteilhaft ist sie auf die Unterseite aufgebracht, wobei sie aufgedruckt sein kann oder in einem sonstigen Beschichtungsverfahren aufgebracht sein kann. Ausschnitte für eine Formgebung eines durch Leuchtmittel auf dem Bauteilträger beleuchteten bzw. hinterleuchteten Symbols können entweder aus der Abdeckschicht herausgearbeitet werden, beispielsweise herausgelasert werden. Alternativ können sie bereits bei Herstellung der Abdeckschicht freigelassen werden, so dass diese Abdeckschicht dann eben beispielsweise in einem Siebdruckverfahren aufgebracht wird. Vor allem durch ein Herausarbeiten mit einem Laser ist eine einfache und variable Gestaltung möglich, die auch relativ einfach verändert werden kann, so dass auch eine kleinserientechnische Herstellung möglich ist.

In Ausgestaltung der Erfindung weist der Flexträger eine einzige elektrische Kontaktiereinrichtung auf. Diese kann einen vorzugsweise frei beweglichen Kontaktarm aufweisen, der von dem Flexträger zumindest teilweise frei ist, also sozusagen beweglich. Vorteilhaft verläuft der Kontaktarm innerhalb des Flexträgers bzw. innerhalb von dessen Fläche und kann einen Abstand zu einem umlaufenden Außenrand des Flexträgers aufweisen, der mindestens 2cm beträgt, vorteilhaft mindestens 4cm. In diesem Fall ist also der Kontaktarm völlig innerhalb des Außenrands des Flexträgers vorgesehen, so dass bei Anordnung von Flexträger und auch Bauteilträger in einem Gehäuse die elektrische Kontaktierung nicht in einem Eck oder an der Seite stattfinden muss.

Die Kontaktiereinrichtung kann eine Steckeinrichtung sein, vorzugsweise mit Kontaktflächen, die in eine Steckeraufnahme direkt eingeschoben werden können. Diese Steckeraufnahme ist vorteilhaft auf dem Bauteilträger angeordnet. Die Kontaktflächen können beispielsweise gedruckte Carbonleitflächen sein, welche eine sehr gute elektrische Leitfähigkeit und eine sehr gute elektrische Kontaktierbarkeit durch Andrücken ermöglichen.

In weiterer Ausgestaltung der Erfindung kann der Flexträger noch mit einem weiteren Träger verbunden sein, beispielsweise einer dünnen Glas- oder Kunststoffplatte, die vorteilhaft jeweils transparent sind. Durch die Verwendung einer solchen zusätzlichen Tragplatte kann der Flexträger definiert an die Unterseite der Bedienblende angedrückt werden.

Bei dem erfindungsgemäßen Elektrogerät ist die Bedieneinrichtung so eingebaut, dass die Bedienblende an einer Außenseite bzw. Außenwandung des Elektrogeräts angeordnet ist bzw. die Außenseite teilweise bilden kann. Das Elektrogerät ist besonders vorteilhaft ein Kochfeld mit einer Kochfeldplatte, wobei die Kochfeldplatte bzw. ein Teilbereich von ihr die Bedienblende bildet.

Zur Herstellung eines vorbeschriebenen Flexträgers für eine erfindungsgemäße Bedieneinrichtung kann auf den Flexträger Sensormaterial aufgedruckt werden, vorteilhaft auf zuvor aufgebrachte Leitmaterialstrukturen oder Kontaktfelder, welche bereits in etwa die Form des aufzubringenden Sensormaterials haben. Das Sensormaterial kann vorzugsweise eine Acrylat-basierte Co-Polymermatrix aufweisen, die expandiert bzw. aufgeschäumt werden kann. Im Ausgangszustand weist diese Co-Polymermatrix Mikrokugeln auf, die mit Lösemittel gefüllt sind, wodurch eine gute Verteilung des Lösemittels in dem Material möglich ist, ohne dass sich zu große Ansammlungen ergeben. Bei anschließender Temperaturbeaufschlagung dehnt sich das Lösemittel aus, tritt aus den Mikrokugeln aus bzw. zerreißt diese und dehnt sich dann weiterhin aus durch Verdampfen. So wird das Volumen des Materials bzw. des Sensormaterials vergrößert. Gleichzeitig nimmt die Elastizität des Sensormaterials dabei zu, da solche geschäumten bzw. expandierten Kunststoffmaterialien bekanntermaßen eine sehr gute Formelastizität aufweisen.

Vor dem Aufbringen des Sensormaterials wird, wie eingangs erläutert, vorteilhaft das sehr gut elektrisch leitfähige Leitmaterial auf den Flexträger aufgebracht. Dies kann in Form der Leiterbahnen und in Form des Sensormaterials bzw. der kapazitiven Sensorelemente erfolgen. Nach dem Aufbringen des Leitmaterials wird das vorgenannte Sensormaterial auf das Leitmaterial aufgebracht und durch Erwärmen expandiert.

Bevorzugt ist auf den Flexträger eine vollflächige und lichtundurchlässige Beschichtung aufgebracht, beispielsweise durch ein vorbeschriebenes Verfahren. Um die genannten Symbole, Zahlen und/oder Buchstaben zu bilden bzw. herzustellen, wird diese Beschichtung mit einem Laser bearbeitet bzw. bereichsweise entfernt. Bei Hinterleuchtung mit einer Lichtquelle wie beispielsweise einer SMD-LED ist dann von vorne das beleuchtete Symbol odgl. zu erkennen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen:
- Fig. 1: eine Schrägansicht auf einen Flexträger einer erfindungsgemäßen Bedieneinrichtung,
- Fig. 2: eine Schrägansicht auf einen Bauteilträger einer erfindungsgemäßen Bedieneinrichtung in einem Gehäuse zur Halterung,
- Fig. 3: eine Schrägansicht entsprechend Fig. 2 nur des Bauteilträgers mit Bauteilen darauf,
- Fig. 4: eine Schrägansicht entsprechend Fig. 2 nur des Gehäuses,
- Fig. 5: eine Schrägansicht der erfindungsgemäßen Bedieneinrichtung entsprechend Fig. 2 mit angebrachtem Flexträger, aber ohne Bedienblende,
- Fig. 6: eine Seitenansicht einer erfindungsgemäßen Bedieneinrichtung bzw. eines erfindungsgemäßen Kochfelds,
- Fig. 7: eine Vergrößerung einer schrägen Schnittdarstellung durch den Flexträger entsprechend Fig. 1 mit Schnitt durch Sensorelemente und
- Fig. 8: eine Draufsicht auf die Schnittebene des Flexträgers entsprechend Fig. 7.

### Detaillierte Beschreibung des Ausführungsbeispiels

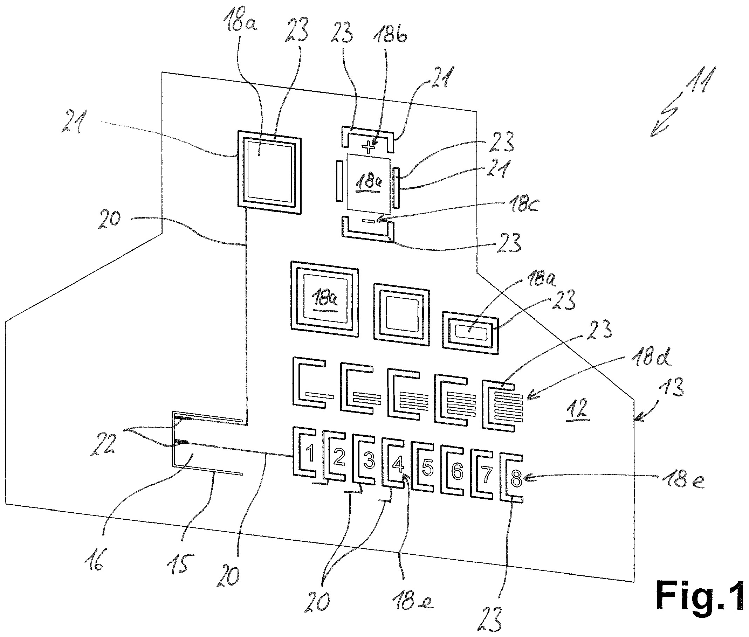

In der Fig. 1 ist in Schrägansicht ein erfindungsgemäßer Flexträger 11 dargestellt mit besonderer Formgebung. Der Flexträger 11 ist eine Folie aus Polycarbonat mit einer Dicke von etwa 0,2mm. So ist er einerseits flexibel bzw. gut biegbar, wie nachher noch mit Bezug auf die Kontaktiereinrichtung beschrieben wird. Andererseits weist er eine gewisse Eigenstabilität auf ohne wie eine sehr dünne Folie leicht zu wellen odgl..

Der Flexträger 11 weist eine Oberseite 12 und eine Unterseite 13 auf. Auf der hier zu sehenden Oberseite 12 sind im linken unteren Bereich Einschnitte 15 nach Art eines U vorgesehen, die einen Kontaktarm 16 einer eingangs genannten Kontaktiereinrichtung bilden. Dieser Kontaktarm 16 kann durch die Flexibilität des Flexträgers 11 leicht nach unten oder nach oben aus der Ebene des ansonsten flachen Flexträgers 11 herausgebogen werden.

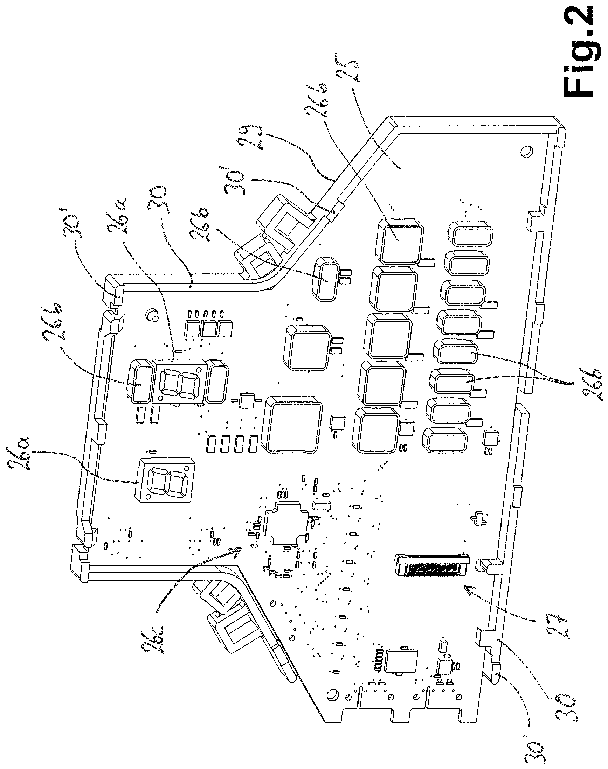

Der Flexträger 11 weist des Weiteren lichtdurchlässige Bereiche 18 auf, die unterschiedliche Ausbildungen haben. Es sind lichtdurchlässige Bereiche 18a vorgesehen in Form von rechteckigen Feldern. Die beiden oberen lichtdurchlässigen Bereiche 18a sind für sogenannte Sieben-Segment-Anzeigen vorgesehen, wie sie nachfolgend in Fig. 2 dargestellt sind. Der lichtdurchlässige Bereich 18b ist ein Plus-Symbol und der lichtdurchlässige Bereich 18c ein Minus-Symbol. Des Weiteren sind lichtdurchlässige Bereiche 18d vorgesehen in Form von Balkenanzeigen mit einer zunehmenden Anzahl von Balken übereinander. Schließlich sind noch lichtdurchlässige Bereiche 18e vorgesehen in Form der Ziffern 1 bis 8. Die lichtdurchlässigen Bereiche 18 sind in einer Beschichtung an der Unterseite 13 des Flexträgers 11 eingebracht. Der Flexträger 11 ist an sich lichtdurchlässig bzw. im Wesentlichen durchsichtig. Auf seine Unterseite 13 wird, wie eingangs erläutert, großflächig bzw. vollflächig eine lichtundurchlässige Beschichtung aufgebracht, beispielsweise aufgewalzt oder aufgesprüht. Diese Beschichtung ist so ausgebildet, dass sie auf bekannte Art und Weise beispielsweise mit einem Laser strukturiert werden kann bzw. dass die lichtdurchlässigen Bereiche 18 herausgearbeitet werden können. So ist eine individuelle und für kleine Stückzahlen von Flexträgern 11 geeignete Herstellung möglich. Alternativ kann eine Beschichtung so aufgebracht werden, dass die lichtdurchlässigen Bereiche 18 gleich frei bleiben.

Auf der Oberseite 12 des Flexträgers 11 sind Leiterbahnen 20 dargestellt, wobei nur zwei Leiterbahnen 20 vollständig dargestellt sind. Die Leiterbahnen 20 bestehen aus eingangs genanntem gut leitfähigem Leitmaterial, beispielsweise hergestellt mittels einer Carbonleitpaste, einer Silberleitpaste oder eines Leitlacks. Sie können vorteilhaft in einem Siebdruckverfahren auf die Oberseite 12 aufgebracht werden. Die Leiterbahnen 20 gehen jeweils auf den Kontaktarm 16 und enden dort in Kontaktfeldern 22. Diese Kontaktfelder 22 wiederum bestehen vorteilhaft aus gedruckten Carbonleitflächen, wie eingangs genannt, so dass das freie Ende des Kontaktarms 16 gleichzeitig eine Art Steckeinrichtung bildet, die in eine entsprechend ausgestaltete Steckeraufnahme eingesteckt werden kann. Hierzu kann zur Verstärkung des Kontaktarms 16 am Ende eine weitere Schicht Polycarbonatfolie oder auch ein etwas stärkeres Material aufgeklebt sein. Falls die Breite des Kontaktarms 16 nicht ausreichen sollte für alle Leiterbahnen 20, können an einer Unterseite 13 des Flexträgers 11 ebenfalls Leiterbahnen verlaufen, die mit einer Durchkontaktierung von oben nach unten elektrisch auf die Oberseite 12 kontaktiert sind.

Die Leiterbahnen 20 sind im Bereich der lichtdurchlässigen Bereiche 18 an Leitfelder 21 aus demselben Leitmaterial geführt bzw. zusammen mit diesen Leitfeldern 21 hergestellt. Die Leitfelder 21 weisen im Wesentlichen dieselbe Form auf wie darauf aufgebrachte Sensorelemente 23, so dass die Leitfelder 21 die elektrische Kontaktierung der Leiterbahnen 20 an die Sensorelemente 23 bilden.

Die Sensorelemente 23 sind in verschiedener Form ausgebildet. An den lichtdurchlässigen Bereichen 18a sind es zum Teil rechteckige, umlaufende Rahmen. Im Bereich der lichtdurchlässigen Bereiche 18b und 18c sind es einzelne Segmente bzw. U-förmige Abschnitte, ebenso wie an den lichtdurchlässigen Bereichen 18d und 18e. Dies reicht, um jeweils kapazitive Sensorelemente zu bilden. Wie aus den späteren Darstellungen deutlicher wird, ist das Sensormaterial der Sensorelemente 23 nicht so flach und dünn wie beispielsweise die Leiterbahnen 20 und die Leitfelder 21, deren Höhe üblicherweise 0,1mm oder eher weniger beträgt. Dies wird später noch näher erläutert.

In der Fig. 2 ist ein Bauteilträger 25 in Form einer Leiterplatte dargestellt mit einer Außenkontur ähnlich derjenigen des Flexträgers 11. Auf einer Oberseite des Bauteilträgers 25 sind zwei Sieben-Segment-Anzeigen 26a vorgesehen. Des Weiteren sind sogenannte Leuchtkappen 26b angeordnet, welche Kunststoffgehäuse sind über einer SMD-LED oder mehreren solcher LED, die lichtdurchlässiges Material mit einer Diffusorwirkung aufweisen zur Durchleuchtung durch die lichtdurchlässigen Bereiche 18b bis 18e in Form von Symbolen am Flexträger 11.

Außerdem sind am Bauteilträger 25 noch passive Bauteile 26c vorgesehen, unter Umständen auch eine eingangs genannte Steuerung bzw. ein Mikrocontroller. Schließlich ist noch eine Steckeraufnahme 27 dargestellt, in welche der Kontaktarm 16 des Flexträgers 11 mit den Kontaktfeldern 22 eingesteckt werden kann.

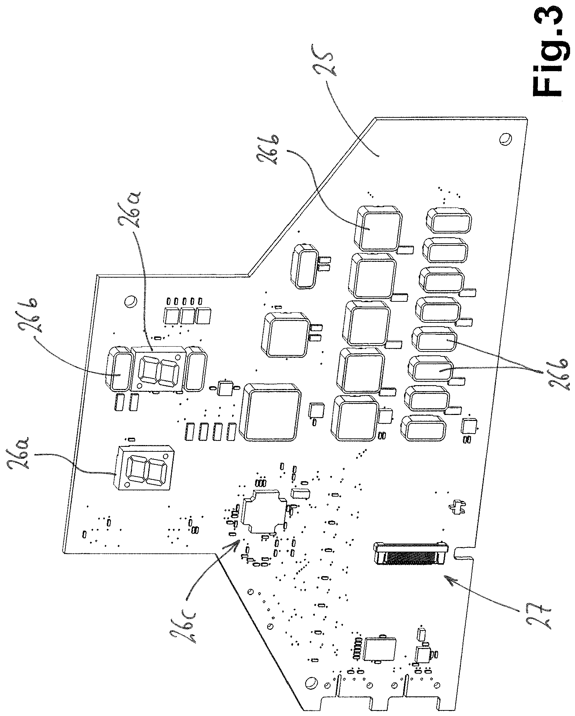

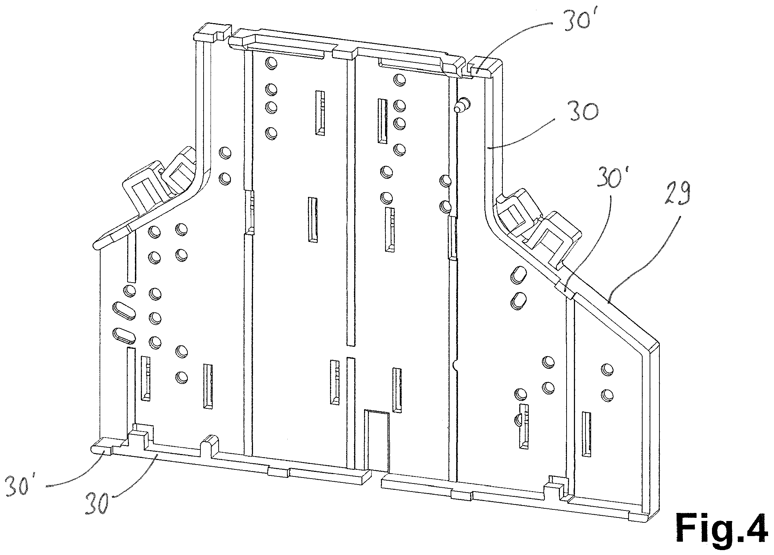

Der Bauteilträger 25, der in der Fig. 3 noch einmal in derselben Ansicht alleine dargestellt ist, ist in einem Gehäuse 29 entsprechend Fig. 4 gelagert. Diese ist eine an sich übliche Lagerung, zu der nicht viel zu sagen ist. Sie ist positionsgenau durch eine Rastverbindung hergestellt.

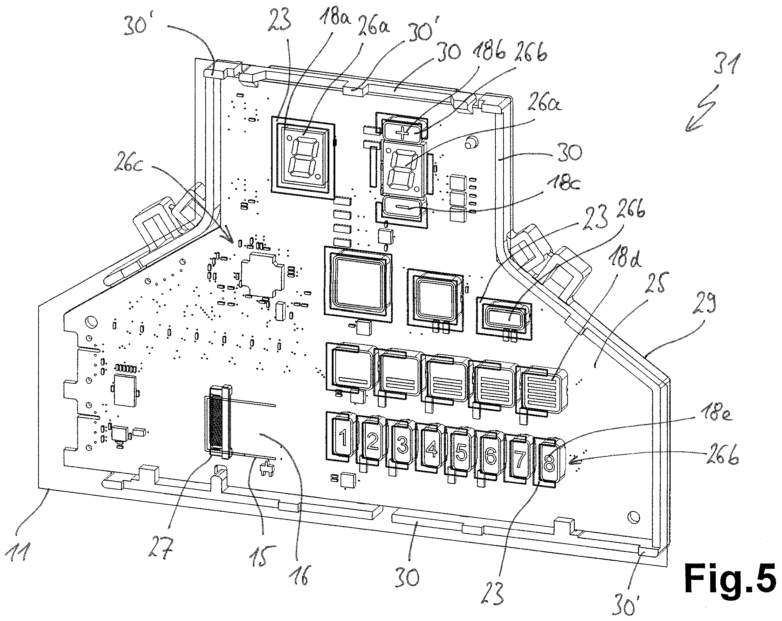

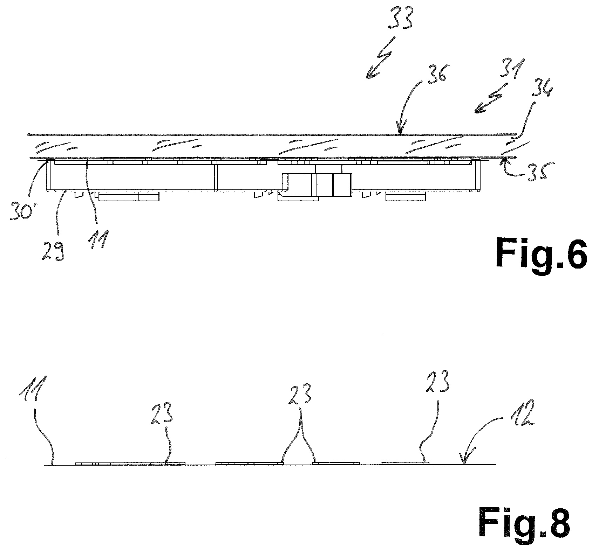

In der Fig. 5 ist eine Bedieneinrichtung 31 fast komplett dargestellt, nur die Bedienblende fehlt, welche dann aber aus der Fig. 6 zu ersehen ist. Die Fig. 5 zeigt, dass der Flexträger 11 oberhalb des Bauteilträgers 25 im Gehäuse 29 angeordnet ist und dabei das Gehäuse 29 selbst seitlich etwas überragt. Dies muss nicht sein, kann aber so vorgesehen sein. Ein Rand 30 des Gehäuses 29 kann dabei so hoch sein, dass der Flexträger 11 sowohl seitlich umlaufend auf diesem Rand aufliegt als auch auf den passiven Bauteilen des Bauteilträgers 25, zumindest den Sieben-Segment-Anzeigen 26a und Leuchtkappen 26b. Dazu weist hier der Rand 30 des Gehäuses Randerhöhungen 30' auf, so dass der Flexträger 11 mit seiner Unterseite 13 nicht entlang des gesamten Rands 30 auf dem Gehäuse 29 aufliegt.

Die Schnittdarstellung der Fig. 6 zeigt eine erfindungsgemäße Bedieneinrichtung 31 bzw. ein Kochfeld 33 mit einer Kochfeldplatte 34, die gleichzeitig die Bedienblende der Bedieneinrichtung 31 bildet. An einer Unterseite 35 der Kochfeldpatte 34 liegt der Flexträger 11 mit den Sensorelementen 23 direkt an. Die Höhe der Sensorelemente 23 ist in der Fig. 6 sowie in den nachfolgenden Figuren etwas übertrieben dargestellt, um die Höhenausdehnung an sich deutlich zu machen. Die Sensorelemente 23 sind dabei direkt an die Unterseite 35 gepresst, während die übrige Fläche des Flexträgers 11 einen geringen Abstand aufweisen sollte. Ein Anpressdruck kann beispielsweise über das Gehäuse 29 ausgeübt werden. Legt eine Bedienperson auf eine Oberseite 36 der Kochfeldplatte 34 über einem Sensorelement 23 einen Finger auf, so kann auf übliche Art und Weise ein Schaltvorgang ausgelöst werden wie es der Fachmann von kapazitiven Berührungsschaltern kennt.

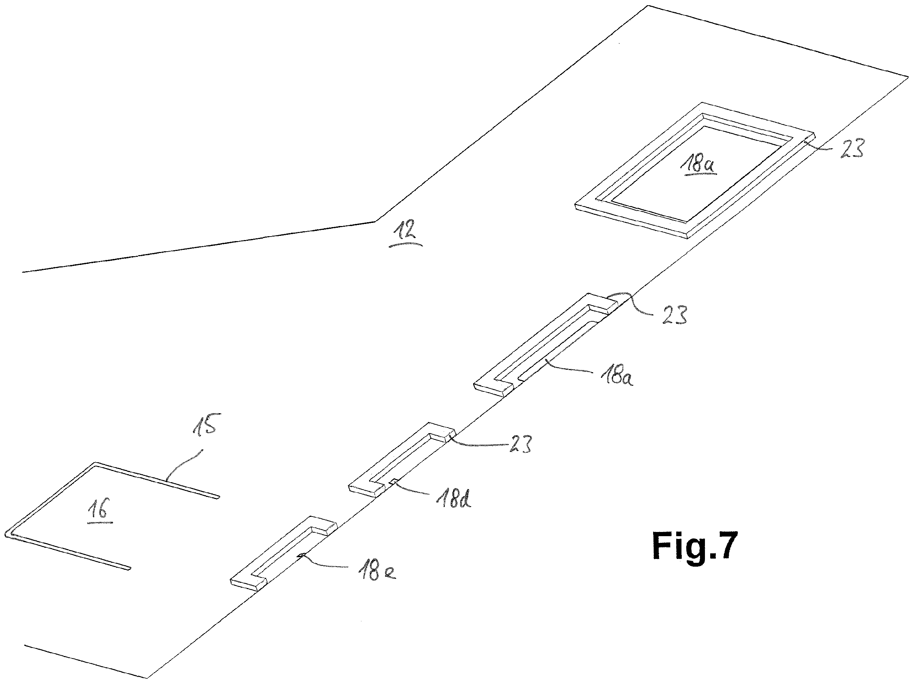

Die schräge Schnittdarstellung der Fig. 7 zeigt den Flexträger 11 alleine mit Ansicht auf seine Oberseite 12. Dabei ist zu ersehen, wie die Sensorelemente 23 bestehend aus dem Sensormaterial tatsächlich eine gewisse Höhe bzw. Erhebung über die Oberseite 12 des Flexträgers 11 aufweisen. Die Höhe kann im eingangs genannten Bereich liegen und sollte mindestens 0,3mm, besser mindestens 0,5mm betragen und vorzugsweise bis zu 0,8mm gehen. Dabei ist darauf zu achten, dass der Wunsch nach einer größeren Höhe der Sensorelemente 23 nicht zu sehr zu Lasten der Definiertheit bzw. Schärfe der Form geht. Die hier dargestellten rechteckigen, streifenförmigen oder gewinkelten Verläufe der Sensorelemente 23 sollten einigermaßen eingehalten werden.

Die vorgenannte Höhe der Sensorelemente 23 zusammen mit deren Aufbau aus dem eingangs genannten, expandierten bzw. aufgeschäumten Sensormaterial verleiht den Sensorelementen 23 eine gewisse Flexibilität und Elastizität in Richtung senkrecht zu der Fläche des Flexträgers 11. So ist ein etwas flexibles Andrücken der Sensorelemente 23 an die Unterseite 35 der Kochfeldplatte 34 möglich trotz einer für Kochfeldplatten aus Glaskeramik üblichen Noppung an der Unterseite. Durch gleichmäßig bzw. sozusagen vollflächig entsprechend ihrer Länge anliegende Sensorelemente 23 ist ein definiertes und vorteilhaftes elektrisches Verhalten der dadurch gebildeten kapazitiven Berührungsschalter erreicht.

Ebenso sind in der Fig. 7 noch kleine Ausschnitte der lichtdurchlässigen Bereiche 18a, 18d und 18e zu erkennen.

Diese Höhe der Sensorelemente 23 ist in der Darstellung der Fig. 8 mit der Seitenansicht des Flexträgers 11 alleine noch einmal gut zu ersehen. Durch einen relativ geringen Druck von beispielsweise 1N bis 5N oder sogar 10N können die Sensorelemente 23 leicht etwa auf ihre halbe Höhe zusammengedrückt werden. Das eingangs genannte Material für die Sensorelemente mit der Acrylat-basierten Co-Polymermatrix, die elektrisch leitfähig gemacht ist, weist eine Elastizität bzw. Flexibilität auf, die auch durch Alterung sowie Temperaturschwankungen oder höhere Temperaturen, wie sie an einer Bedieneinrichtung in einem Kochfeld auftauchen können, nicht zu negativ beeinträchtigt wird.

Zur Herstellung eines solchen Flexträgers wird eine Ausgangsfolie aus Polycarbonat an ihrer Unterseite 13 mit der lichtundurchlässige Beschichtung versehen, vorteilhaft großflächig bedruckt. Dann wird diese an der Unterseite mit einem Laser bearbeitet bzw. die lichtdurchlässigen Bereiche 18 werden herausgearbeitet. Des Weiteren werden die Einschnitte 15 angebracht zur Herausbildung des Kontaktarms 16. Anschließend wird auf die Oberseite 12 des Flexträgers 11 das Leitmaterial aufgebracht, vorteilhaft durch Siebdruck, um die Leiterbahnen 20 und die Leitfelder 21 zu bilden. Darauf werden dann einerseits die Kontaktfelder 22 im Bereich des Kontaktarms 16 aufgebracht. Des Weiteren wird das Sensormaterial für die Sensorelemente 23 aufgebracht, vorteilhaft in einem Schablonendruckverfahren, welches bei den hier dargestellten, relativ kleinen Dimensionen der Strukturen mit Breiten im Millimeter-Bereich bessere Ergebnisse liefert. Das Sensormaterial im Ausgangszustand kann mit einer Dicke von etwa 0,1mm bis 0,4mm und Breite von 0,3mm bis 2mm aufgedruckt werden. Durch thermische Beaufschlagung expandiert es bzw. wird aufgeschäumt zu einer Höhe von etwa 0,5mm bis 0,8mm und einer Breite von 0,5mm bis 3mm.

Der so erhaltene Flexträger 11 ähnlich der Fig. 1 kann dann in eine Bedieneinrichtung entsprechend der Fig. 5 und 6 eingebaut werden.

In weiterer Ausgestaltung der Erfindung ist es möglich, auf dem Flexträger 11, insbesondere an seiner Unterseite 13, noch weitere aktive und/oder passive Bauteile aufzubringen wie beispielsweise Transistoren, Kondensatoren oder Multiplexer. So ist beispielsweise eine direkte Wandlung eines analogen Sensorelementsignals in unmittelbarer Nähe zu deren Entstehen möglich, also durch entsprechende Bauteile ganz nahe bei den Sensorelementen 23. Dadurch wäre eine deutliche Verbesserung des Signal-Rausch-Abstands möglich und somit eine gesteigerte Robustheit gegenüber externen Störeinflüssen. Selbst längere Verbindungsleitungen zu einem zentralen Mikrocontroller könnten so realisiert werden. Hierfür sind dann vor allem Durchkontaktierungen von der Oberseite 12 zur Unterseite 13 notwendig.

## Patentansprüche

1. Bedieneinrichtung (31) für ein Elektrogerät (33) mit einem kapazitiven Berührungsschalter, insbesondere für ein Kochfeld, aufweisend:
- eine Bedienblende (34),
- einen Bauteilträger (25), der unter der Bedienblende (34) angeordnet ist,
- auf dem Bauteilträger (25) angeordnete Bauteile (26a-c), welche mindestens elektrische Schaltungsbauteile (26c) und Leuchtanzeigen bzw. Leuchtmittel (26a) aufweisen,
- unterhalb der Bedienblende (34) und oberhalb der Bauteile (26a-c) verläuft über dem Bauteilträger (25) ein flexibler Träger bzw. ein Folienträger als Flexträger (11),
- der Flexträger (11) ist zumindest bereichsweise (18a-e) lichtdurchlässig,
- Leuchtmittel (26a) auf dem Bauteilträger (25) unter den lichtdurchlässigen Bereichen (18a-e),
- elektrisch leitfähiges elastisches Sensormaterial (23) zur Bildung des kapazitiven Berührungsschalters auf der Oberseite (12) des Flexträgers (11),
- Leiterbahnen (20) auf dem Flexträger (11), die einerseits mit dem Sensormaterial (23) elektrisch verbunden sind und andererseits an eine Kontaktierungseinrichtung (16, 22) des Flexträgers geführt sind,
**dadurch gekennzeichnet, dass**
- das Sensormaterial (23) eine Höhe zwischen 0,1mm und 2mm über die Oberfläche des Flexträgers (11) aufweist,
- das Sensormaterial eine Acrylat-basierte Co-Polymermatrix aufweist, die expandiert bzw. aufgeschäumt worden ist, wobei die Acrylat-basierte Co-Polymermatrix im Ausgangszustand mit Lösemittel gefüllte Mikrokugeln aufweist, die sich bei Temperaturbeaufschlagung nach dem Auftragen des Sensormaterials (23) auf den Flexträger ausgedehnt haben und somit das Volumen des Sensormaterials vergrößert haben,
- dem Sensormaterial (23) Leitadditive zugesetzt sind, die ein Leitnetzwerk bilden.

2. Bedieneinrichtung nach Anspruch 1, **dadurch gekennzeichnet, dass** das Sensormaterial (23) ausschließlich an der Oberseite (12) des Flexträgers (11) angeordnet ist.

3. Bedieneinrichtung nach Anspruch 1 oder 2, **dadurch gekennzeichnet, dass** die Leiterbahnen (20) auf der Oberseite (12) des Flexträgers (11) angeordnet sind, vorzugsweise ausschließlich auf der Oberseite des Flexträgers.

4. Bedieneinrichtung nach einem der vorhergehenden Ansprüche, **dadurch gekennzeichnet, dass** das Volumen des Sensormaterials (23) um den Faktor 3 bis 8 vergrößert ist.

5. Bedieneinrichtung nach einem der vorhergehenden Ansprüche, **dadurch gekennzeichnet, dass** die Leitadditive aus der folgenden Gruppe sind: Carbon-Nanofasern, Ag-beschichtete Glaspartikel, PEDOT:PSS, Graphit.

6. Bedieneinrichtung nach einem der vorhergehenden Ansprüche, **dadurch gekennzeichnet, dass** das Sensormaterial (23) benachbart zu lichtdurchlässigen Bereichen (17a-e) des Flexträgers (11) angeordnet ist, vorzugsweise zu einem lichtdurchlässigen Bereich (17a-e) an mindestens zwei Seiten, insbesondere an drei Seiten oder an allen vier Seiten ganz umgebend.

7. Bedieneinrichtung nach einem der vorhergehenden Ansprüche, **dadurch gekennzeichnet, dass** das Sensormaterial (23) in einem Druckverfahren auf den Flexträger (11) bzw. auf das Leitmaterial aufgebracht ist, vorzugsweise in einem Siebdruckverfahren oder Schablonendruckverfahren.

8. Bedieneinrichtung nach einem der vorhergehenden Ansprüche, **dadurch gekennzeichnet, dass** direkt auf den Flexträger (11) sehr gut elektrisch leitfähiges Leitmaterial (21) aufgedruckt ist mit der Form des Sensormaterials, wobei von diesem Leitmaterial (21) die Leiterbahnen (20) abgehen, insbesondere beide aus demselben Leitmaterial und im selben Schritt aufgebracht sind, wobei auf dieses Leitermaterial (21) das Sensormaterial (23) aufgebracht ist.

9. Bedieneinrichtung nach einem der vorhergehenden Ansprüche, **dadurch gekennzeichnet, dass** das Leitmaterial (21) bzw. die Leiterbahnen (20) in einem Druckverfahren auf den Flexträger (11) aufgebracht ist, vorzugsweise in einem Siebdruckverfahren oder Schablonendruckverfahren.

10. Bedieneinrichtung nach einem der vorhergehenden Ansprüche, **dadurch gekennzeichnet, dass** auf den Flexträger (11) eine lichtundurchlässige Abdeckschicht aufgebracht ist, insbesondere auf die Unterseite, wobei insbesondere Ausschnitte als lichtdurchlässige Bereiche für eine Formgebung eines durch Leuchtmittel (26) auf dem Bauteilträger (25) beleuchteten Symbols entweder aus der Abdeckschicht herausgearbeitet sind oder bei Herstellung der Abdeckschicht freigelassen sind.

11. Bedieneinrichtung nach einem der vorhergehenden Ansprüche, **dadurch gekennzeichnet, dass** der Flexträger (11) eine einzige Kontaktiereinrichtung (16, 22) aufweist, vorzugsweise mit einem frei beweglichen, von dem Flexträger (11) teilweise freien Kontaktarm (16), wobei vorzugsweise der Kontaktarm (16) innerhalb des Flexträgers (11) und innerhalb von dessen Fläche mit einem Abstand zu einem umlaufenden Außenrand des Flexträgers (11) von mindestens 2cm verläuft, insbesondere mindestens 5cm.

12. Bedieneinrichtung nach Anspruch 11, **dadurch gekennzeichnet, dass** die Kontaktiereinrichtung (16, 22) eine Steckeinrichtung ist, vorzugsweise mit Kontaktflächen (22) zum Einstecken in eine Steckeraufnahme (27).

13. Elektrogerät mit einer Bedieneinrichtung (31) nach einem der vorhergehenden Ansprüche, **dadurch gekennzeichnet, dass** die Bedienblende (34) der Bedieneinrichtung (31) an einer Außenseite bzw. Außenwandung des Elektrogeräts (33) angeordnet ist, wobei vorzugsweise das Elektrogerät ein Kochfeld (33) mit Kochfeldplatte (34) ist und die Kochfeldplatte die Bedienblende bildet.

14. Verfahren zur Herstellung eines Flexträgers (11) für eine Bedieneinrichtung (31) nach einem der Ansprüche 1 bis 12, **gekennzeichnet durch** die folgenden Schritte:
- es werden ein Flexträger (11) bereit gestellt und eine Acrylat-basierte Co-Polymermatrix bereit gestellt, die expandiert bzw. aufgeschäumt werden kann, wobei die Acrylat-basierte Co-Polymermatrix im Ausgangszustand mit Lösemittel gefüllte Mikrokugeln aufweist,
- auf den Flexträger (11) wird die Acrylat-basierte Co- Polymermatrix als Sensormaterial (23) aufgedruckt,
- nach dem Auftragen des Sensormaterials (23) auf den Flexträger (11) wird dieser mit Temperatur beaufschlagt, wodurch sich die mit Lösemittel gefüllten Mikrokugeln ausdehnen und somit das Volumen des Sensormaterials vergrößern, wobei die Elastizität des Sensormaterials dabei zunimmt.

15. Verfahren nach Anspruch 14, **dadurch gekennzeichnet, dass** elektrisch sehr gut elektrisch leitfähiges Leitmaterial (21, 22) in einem vorausgehenden Schritt auf den Flexträger aufgebracht worden ist, vorzugsweise als Leiterbahnen (21) und in Form des Sensormaterials (23), und danach zumindest teilweise das Sensormaterial (23) auf das Leitmaterial (21, 22).

16. Verfahren nach Anspruch 14 oder 15, **dadurch gekennzeichnet, dass** auf den Flexträger (11) eine vollflächige lichtundurchlässige Beschichtung aufgebracht wird und danach mit einem Laser bearbeitet wird zur Herstellung von Symbolen, Zahlen und/oder Buchstaben.

## Claims

1. Operating device (31) for an electrical appliance (33) with a capacitive touch switch, in particular for a cooktop, comprising:
- an operator control panel (34),
- a component carrier (25) which is disposed underneath the operator control panel (34),
- components (26a-c) disposed on the component carrier (25), which components include at least electrical circuit components (26c) and luminous displays or illuminants (26a),
- a flexible carrier or a film carrier as a flex carrier (11) extending underneath the operator control panel (34) and above the components (26a-c) across the component carrier (25),
- the flex carrier (11) being translucent at least in sections (18a-e),
- illuminants (26a) on the component carrier (25) underneath the translucent sections (18a-e),
- electrically conductive elastic sensor material (23) for providing the capacitive touch switch on the upper side (12) of the flex carrier (11),
- conductive paths (20) on the flex carrier (11) which are electrically connected to the sensor material (23), on the one hand side, and are guided to a contacting device (16, 22) of the flex carrier, on the other hand side,
**characterized in that**
- the sensor material (23) has a height between 0.1 mm and 2 mm over the surface of the flex carrier (11),
- the sensor material has an acrylate-based copolymer matrix which has been expanded or foamed, wherein the acrylate-based copolymer matrix in an initial condition includes solvent filled microspheres which have expanded upon temperature increase following application of the sensor material (23) onto the flex carrier and, thus, have increased the volume of the sensor material,
- the sensor material (23) has conductive additives included which form a conducting network.

2. Operating device according to claim 1, **characterized in that** the sensor material (23) is arranged exclusively on the upper side (12) of the flex carrier (11).

3. Operating device according to claim 1 or 2, **characterized in that** the conductive paths (20) are arranged on the upper side (12) of the flex carrier (11), preferably exclusively on the upper side of the flex carrier.

4. Operating device according to any of the preceding claims, **characterized in that** the volume of the sensor material (23) is increased by a factor of 3 to 8.

5. Operating device according to any of the preceding claims, **characterized in that** the conductive additives are selected from the following group: carbon nanofibres, Agcoated glass particles, PEDOT:PSS, graphite.

6. Operating device according to any of the preceding claims, **characterized in that** the sensor material (23) is disposed adjacent to translucent sections (17a-e) of the flex carrier (11), preferably to one translucent section (17a-e) at least on two sides, in particular on three sides or on all four sides fully enclosing.

7. Operating device according to any of the preceding claims, **characterized in that** the sensor material (23) is applied onto the flex carrier (11) or onto the conductive material in a printing process, preferably using a screen printing process or stencil printing process.

8. Operating device according to any of the preceding claims, **characterized in that** very well electrically conducting conductive material (21) having the shape of the sensor material is printed directly on the flex carrier (11), wherein the conductive paths (20) go out from said conductive material (21), in particular both are applied of the same conductive material and in the same step, wherein the sensor material (23) is applied onto said conductive material (21).

9. Operating device according to any of the preceding claims, **characterized in that** the conductive material (21) or the conductive paths (20) are applied onto the flex carrier (11) in a printing process, preferably using a screen printing process or stencil printing process.

10. Operating device according to any of the preceding claims, **characterized in that** an opaque cover layer is applied onto the flex carrier (11), in particular onto the underside, wherein in particular sectors as translucent sections for shaping of a symbol illuminated by illuminants (26) on the component carrier (25) are prepared out of the cover layer or are left blank during production of the cover layer.

11. Operating device according to any of the preceding claims, **characterized in that** the flex carrier (11) has a single contacting device (16, 22), preferably with a freely movable contact arm (16) partially free from the flex carrier (11), wherein preferably the contact arm (16) extends within the flex carrier (11) and within the surface area thereof at a distance of at least 2 cm, in particular at least 5 cm, from a circumferential outer edge of the flex carrier (11).

12. Operating device according to claim 11, **characterized in that** the contacting device (16, 22) is a plug-in device, preferably with contact surfaces (22) for plugging into a connector holder (27).

13. Electrical appliance, comprising an operating device (31) according to any of the preceding claims, **characterized in that** the operator control panel (34) of the operating device (31) is arranged on an outer side or outer wall of the electrical appliance (33), wherein preferably the electrical appliance is a cooktop (33) with a cooking plate (34) and the cooking plate forms the operator control panel.

14. Method for producing a flex carrier (11) for an operating device (31) according to any of the claims 1 to 12, **characterized by** the following steps:
- a flex carrier (11) is provided and an acrylate-based copolymer matrix is provided, which can be expanded or foamed, wherein the acrylate-based copolymer matrix in an initial condition includes solvent filled microspheres,
- the acrylate-based copolymer matrix is printed onto the flex carrier (11) as a sensor material (23),
- subsequent to the application of the sensor material (23) onto the flex carrier (11), the latter is subject to a temperature increase, as a result, the solvent filled microspheres expand and, thus, increase the volume of the sensor material, with the elasticity of the sensor material increasing thereby.

15. Method according to claim 14, **characterized in that** electric very well electrically conducting conductive material (21, 22) had been applied to the flex carrier in a previous step, preferably as conductive paths (21) and in the form of the sensor material (23), and subsequently at least partially the sensor material (23) onto the conductive material (21, 22).

16. Method according to claim 14 or 15, **characterized in that** a full surface opaque coating is applied onto the flex carrier (11) and, subsequently, is laser processed for producing symbols, figures and/or letters.

## Revendications

1. Dispositif de réglage (31) pour un appareil électrique (33), comprenant un commutateur capacitif à effleurement, en particulier pour une table de cuisson, présentant :
- un panneau de réglage (34),
- un support de composants (25) disposé sous le panneau de réglage (34),
- des composants (26a-c) disposés sur le support de composants (25) qui comprennent au moins des composants de circuit électrique (26c) et des témoins lumineux ou des moyens lumineux (26a),
- un support souple ou un support de film en tant que support flexible (11) s'étend au-dessous du panneau de réglage (34) et au-dessus des composants (26a-c),
- le support flexible (11) est transparent au moins par endroits (18a-e),
- des moyens lumineux (26a) sur le support de composants (25) sous les zones transparentes (18a-e),
- un matériau de détection élastique et électriquement conducteur (23) pour former le commutateur capacitif à effleurement sur la face supérieure (12) du support flexible (11),
- des pistes conductives (20) sur le support flexible (11) qui sont électriquement reliées au matériau de détection (23), d'une part, et sont guidées vers un dispositif de contact (16, 22) du support flexible, d'autre part,
**caractérisé en ce que**
- le matériau de détection (23) présente une hauteur comprise entre 0,1 mm et 2 mm au-dessus de la surface du support flexible (11),
- le matériau de détection présente une matrice de copolymère à base d'acrylate qui a été expansée ou moussée, la matrice de copolymère à base d'acrylate présentant à l'état initial des microbilles remplies de solvant qui se sont dilatées lors d'une mise en température après l'application du matériau de détection (23) au support flexible et ont donc augmenté le volume du matériau de détection,
- des additifs conducteurs sont ajoutés au matériau de détection (23) et forment un réseau de conduction.

2. Dispositif de réglage selon la revendication 1, **caractérisé en ce que** le matériau de détection (23) est disposé exclusivement sur la face supérieure (12) du support flexible (11).

3. Dispositif de réglage selon la revendication 1 ou 2, **caractérisé en ce que** les pistes conductives (20) sont disposées sur la face supérieure (12) du support flexible (11), de préférence exclusivement sur la face supérieure du support flexible.

4. Dispositif de réglage selon l'une quelconque des revendications précédentes, **caractérisé en ce que** le volume du matériau de détection (23) est augmenté d'un facteur de 3 à 8.

5. Dispositif de réglage selon l'une quelconque des revendications précédentes, **caractérisé en ce que** les additifs conducteurs sont issus du groupe suivant : des nanofibres de carbone, des particules de verre plaquées Ag, du PEDOT:PSS, du graphite.

6. Dispositif de réglage selon l'une quelconque des revendications précédentes, **caractérisé en ce que** le matériau de détection (23) est disposé de manière adjacente à des zones transparentes à la lumière (17a-e) du support flexible (11), de préférence à une zone transparente (17a-e) sur au moins deux côtés, en particulier sur trois côtés ou en l'entourant complètement sur l'ensemble des quatre côtés.

7. Dispositif de réglage selon l'une quelconque des revendications précédentes, **caractérisé en ce que** le matériau de détection (23) est appliqué au support flexible (11) ou au matériau conducteur par un procédé d'impression, de préférence par un procédé de sérigraphie ou d'impression au pochoir.

8. Dispositif de réglage selon l'une quelconque des revendications précédentes, **caractérisé en ce qu'**un matériau conducteur (21) à très bonne conductivité électrique est imprimé directement sur le support flexible (11) selon la forme du matériau de détection, les pistes conductives (20) partant de ce matériau conducteur (21), en particulier les deux étant composés du même matériau conducteur et appliqués dans la même étape, le matériau de détection (23) étant appliqué sur ce matériau conducteur (21).

9. Dispositif de réglage selon l'une quelconque des revendications précédentes, **caractérisé en ce que** le matériau conducteur (21) ou les pistes conductives (20) est/sont appliqué(es) au support flexible (11) par un procédé d'impression, de préférence par un procédé de sérigraphie ou d'impression au pochoir.

10. Dispositif de réglage selon l'une quelconque des revendications précédentes, **caractérisé en ce qu'**une couche de recouvrement opaque est appliquée au support flexible (11), en particulier sur la face inférieure, dans lequel en particulier des découpes comme des zones transparentes pour une mise en forme d'un symbole éclairé par des moyens lumineux (26) sur le support de composants (25) sont élaborées à partir de la couche de recouvrement ou sont exposées lors de la fabrication de la couche de recouvrement.

11. Dispositif de réglage selon l'une quelconque des revendications précédentes, **caractérisé en ce que** le support flexible (11) présente un seul dispositif de contact (16, 22), de préférence avec un bras de contact (16) librement mobile et partiellement dégagé du support flexible (11), dans lequel le bras de contact (16) s'étend de préférence à l'intérieur du support flexible (11) et à l'intérieur de la surface de celui-ci à une distance d'un bord extérieur périphérique du support flexible (11) d'au moins 2 cm, en particulier d'au moins 5 cm.

12. Dispositif de réglage selon la revendication 11, **caractérisé en ce que** le dispositif de contact (16, 22) est un dispositif enfichable, de préférence muni de surfaces de contact (22) à enficher dans une prise (27).

13. Appareil électrique, comprenant un dispositif de réglage (31) selon l'une quelconque des revendications précédentes, **caractérisé en ce que** le panneau de réglage (34) du dispositif de réglage (31) est disposé sur une face extérieure ou une paroi extérieure de l'appareil électriques (33), l'appareil électrique étant de préférence une table de cuisson (33) avec une plaque de table de cuisson (34) et la plaque de table de cuisson formant le panneau de réglage.

14. Procédé de fabrication d'un support flexible (11) pour un dispositif de réglage (31) selon l'une quelconque des revendications 1 à 12, **caractérisé par** les étapes suivantes consistant à :
- fournir un support flexible (11) et une matrice de copolymère à base d'acrylate qui peut être expansée ou moussée, la matrice de copolymère à base d'acrylate présentant à l'état initial des microbilles remplies de solvant,
- imprimer la matrice de copolymère à base d'acrylate sur le support flexible (11) en tant que matériau de détection (23),
- après l'application du matériau de détection (23) sur le support flexible (11), mettre celui-ci en température, de sorte que les microbilles remplies de solvant se dilatent et augmentent ainsi le volume du matériau de détection, l'élasticité du matériau de détection augmentant alors.

15. Procédé selon la revendication 14, **caractérisé en ce qu'**un matériau conducteur (21, 22) à très bonne conductivité électrique a été appliqué sur le support flexible dans une étape précédente, de préférence sous forme de pistes conductives (21) et sous la forme du matériau de détection (23), et ensuite le matériau de détection (23) a été appliqué au matériau conducteur (21, 22) au moins en partie.

16. Procédé selon la revendication 14 ou 15, **caractérisé en ce qu'**un revêtement opaque sur toute la surface est appliqué au support flexible (11) et est ensuite traité à l'aide d'un laser pour fabriquer des symboles, des chiffres et/ou des lettres.
